(19) Europäisches Patentamt
European Patent Office
Office européen des brevets

(11) Veröffentlichungsnummer: **0 519 430 A2**

(12) # EUROPÄISCHE PATENTANMELDUNG

(21) Anmeldenummer: **92110240.6**

(51) Int. Cl.$^5$: **C08J 3/24**

(22) Anmeldetag: **17.06.92**

(30) Priorität: **21.06.91 DE 4120505**

(43) Veröffentlichungstag der Anmeldung:
**23.12.92 Patentblatt 92/52**

(84) Benannte Vertragsstaaten:
**BE DE DK ES FR GB IT**

(71) Anmelder: **HOECHST AKTIENGESELLSCHAFT
Postfach 80 03 20
W-6230 Frankfurt am Main 80(DE)**

(72) Erfinder: **Naumann, Joachim
Im Schulzehnten 16
W-6233 Kelkheim (Taunus)(DE)**
Erfinder: **Schmelzer, Heinz
Schlosbergstrasse 15
W-6531 Rümmelsheim(DE)**

(54) **Verfahren zum Härten von heisshärtbaren Präpolymeren.**

(57) Die Erfindung betrifft ein Verfahren zum Härten von heißhärtbaren Präpolymeren, dadurch gekennzeichnet, daß man die Präpolymeren mit einem Härter mischt und dann mit dem heißen Dampf einer perfluorierten organischen Verbindung in Berührung bringt, wobei der Dampf mindestens die Temperatur hat, die für die Härtung des eingesetzten Präpolymeren notwendig ist.

EP 0 519 430 A2

Duroplaste oder duroplastische Kunststoffe sind Kunststoffe, die irreversibel ausgehärtet sind. Sie sind starr und auch bei hohen Temperaturen nicht verformbar.

Duroplaste entstehen durch Vernetzung bestimmter niedermolekularer Vorprodukte, sogenannter Präpolymerer, mit einem Härter. Man unterscheidet Ein- und Zweikomponenten-Systeme, je nachdem ob Präpolymeres und Härter bereits längere Zeit vor der Härtung gemischt und bis zum Härtevorgang in Form einer einzigen Komponente aufbewahrt werden können oder ob sie bis zum Härtevorgang in Form von zwei getrennten Komponenten aufbewahrt werden müssen. Bei den Zweikomponenten-Systemen werden Präpolymeres und Härter (Vernetzer) erst direkt vor dem gewünschten Beginn der Härtung miteinander vermischt und dann bei Raumtemperatur vernetzt (ausgehärtet). Bei den Einkomponenten-Systemen reagieren Präpolymeres und Härter dagegen erst bei erhöhter Temperatur; die dabei verwendeten Präpolymeren werden daher als "heißhärtbare Präpolymere" bezeichnet.

Die Einkomponenten-Duroplaste werden z.B. als Klebstoffe oder Beschichtungen verwendet. Einkomponenten-Klebstoffsysteme können z.B. auf Epoxid-, Polyurethan- oder Acrylbasis hergestellt werden (Wagner-Sarx: "Lackkunstharze" (1959), S. 154 - 157; Patrick: "Treatise on Adhesion and Adhesives" (1969) Vol. 2, Chapter 2.5 "Chemistry and Mechanism of the Cure Process", Chapter 2.6A "Commercial Epoxid Resins", Chapter 2.6B "Curing Agents"; Lee and Neville: "Handbook of Epoxid Resins" (1982) Chapter 1: Epoxid Resins, Chapter 5: Curing; EP 0 046 941).

Nach herkömmlichen Verfahren werden Einkomponenten-Duroplaste häufig durch Erwärmen unter IR-Bestrahlung auf Temperaturen von 120 °C bis 200°C und/oder durch UV-Bestrahlung ausgehärtet. Die Wärmebehandlung ist relativ zeitaufwendig und dauert 5 bis 30 Minuten. Das zweite Verfahren, die UV-Bestrahlung, setzt den Zusatz von UV-Sensibilisatoren voraus und hat den Nachteil, daß die UV-Strahlen die zu klebenden Teile - wenn diese kompliziert aufgebaut sind - nicht überall mit der gleichen Intensität erreichen (Schattenbildung). Deswegen wird die UV-Bestrahlung oft nur in Kombination mit einer Wärmebehandlung (1. Fixierung des Klebers durch UV-Bestrahlung, 2. Härtung durch Wärmeeinwirkung = IR-Bestrahlung) angewendet.

Aus der US-PS 4 721 578 ist ein Verfahren zur Wärmeübertragung auf Werkstücke bekannt, welches auch das Härten von heißhärtbaren Präpolymeren umfaßt, bei dem die Werkstücke mit dem heißen Dampf eines perfluorierten Hexafluorpropenoxid-Oligomeren der Formel

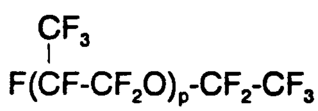

mit p = 1 - 9 in Kontakt gebracht werden.

In der deutschen Patentanmeldung P 40 02 107.6 wird ein Verfahren zum Härten von heißhärtbaren Präpolymeren beschrieben, bei dem man die Präpolymeren mit einem Härter mischt und dann mit dem heißen Dampf eines Perfluorpolyethers der allgemeinen Formel

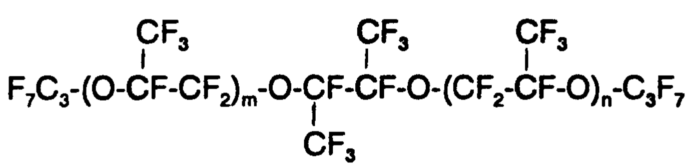

wobei m und n ganze Zahlen von 0 bis 3 sind, in Berührung bringt, wobei der Dampf mindestens die Temperatur hat, die für die Härtung des eingesetzten Präpolymeren notwendig ist.

Gegenstand der vorliegenden Erfindung ist ein Verfahren zum Härten von heißhärtbaren Präpolymeren, dadurch gekennzeichnet, daß man die Präpolymeren mit einem Härter mischt und dann mit dem heißen Dampf einer perfluorierten organischen Verbindung in Berührung bringt, wobei der Dampf mindestens die Temperatur hat, die für die Härtung des eingesetzten Präpolymeren notwendig ist, wobei perfluorierte Verbindungen der Formel

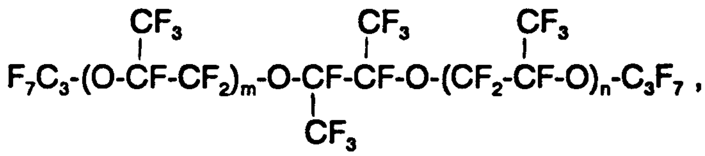

wobei m und n ganze Zahlen von 0 bis 3 sind, und der Formel

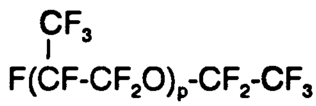 , mit p = 1 - 9

ausgenommen sind.

Vorzugsweise werden folgende perfluorierte organische Verbindungen eingesetzt:

1. Geradkettige oder verzweigte Perfluoralkane mit 5 bis 20 C-Atomen, z.B. Perfluoroctan $C_8F_{18}$ mit einem Siedepunkt von 102 °C, Perfluor-2,3,4-trimethylpentan $C_8F_{18}$ mit einem Siedepunkt von 115 °C, Perfluor-2,4-dimethyl-3-ethylpentan $C_9F_{20}$ mit einem Siedepunkt von 121 °C. Ihre Herstellung wird z.B. in DE-OS 2 332 097 und in EP-A-0 286 131 beschrieben.

2. Cyclische Perfluoralkane mit 10 bis 20 C-Atomen, die auch perfluorierte Alkylsubstituenten enthalten können, z.B. Perfluordekalin, Perfluorbutyldekalin, Perfluorperhydrophenanthren und Perfluorperhydrobenzanthren. Ihre Herstellung wird z.B. in DE-OS 2 000 830, US-PS 4 777 304, EP-A-0 253 529, EP-A-0 190 393 sowie in der Zeitschrift "Tetrahedron", 19 (1963), Seite 1893 ff. beschrieben.

3. Perfluorierte tertiäre Alkylamine, deren Perfluoralkylreste gleich oder verschieden sein können und 1 bis 14 C-Atome haben, wobei zwei der Reste durch O- oder N-Atome verbrückt sein können. Ihre Herstellung wird z.B. in US-PS 2 616 927, DE-OS 3 804 473 und in EP-A-0 271 272 beschrieben.

4. Perfluoraminoether mit der allgemeinen Formel

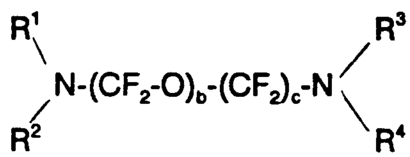

worin bedeuten:

$R^1$ bis $R^4$ gleich oder voneinander verschieden eine Gruppe der Formel

$C_aF_{2a+1}$, wobei a eine ganze Zahl von 1 bis 14 ist,

b, c gleich oder voneinander verschieden eine ganze Zahl von 1 bis 6. Die Herstellung solcher Perfluoraminoether ist z.B. in EP-A-0 214 852 beschrieben. Besonders geeignet sind die folgenden Perfluoraminoether: $(C_2F_5)_2N\text{-}CF_2CF_2OCF_2CF_2\text{-}N(C_3F_7)_2$ mit einem Siedebereich zwischen 195 und 200 °C, $(C_2F_5)_2N\text{-}CF_2CF_2OCF_2CF_2\text{-}N(C_4F_9)_2$ mit einem Siedebereich zwischen 215 und 230 °C, $(C_3F_7)_2N\text{-}CF_2CF_2OCF_2CF_2\text{-}N(C_3F_7)_2$ mit einem Siedebereich zwischen 225 und 240 °C, $(C_3F_7)_2N\text{-}(CF_2)_4O\text{-}(CF_2)_4\text{-}N(C_3F_7)_2$ mit einem Siedebereich zwischen 240 und 260 °C und $(C_3F_7)_2N\text{-}(CF_2)_3O(CF_2)_3\text{-}N(C_3F_7)_2$ mit einem Siedebereich zwischen 240 und 265 °C.

5. Perfluorpolyether der Formel

$R^5\text{-O-(A)-(B)-(C)-}R^6$

worin bedeuten:

| | |
|---|---|
| $R^5$, $R^6$ | gleich oder voneinander verschieden $C_dF_{2d+1}$, wobei d eine ganze Zahl von 1 bis 4 ist, |
| (A), (B) und (C) | verschieden voneinander eine Gruppe der Formel |

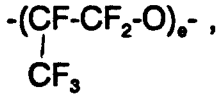 , $-(C_2F_4-O)_f-$ oder 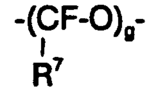

mit
$R^7$ = F oder $CF_3$
e eine ganze Zahl von 1 bis 7 und
f,g gleich oder voneinander verschieden eine ganze Zahl von 0 bis 7.

Die Herstellung dieser Perfluorpolyether ist z.B. in US-PS 3 665 041, US-PS 3 985 810 und in JP-OS Sho 58-103 334 beschrieben.

Das erfindungsgemäße Verfahren zum Härten von heißhärtbaren Präpolymeren kann auf alle üblichen Einkomponenten-Systeme aus Präpolymerem und Härter angewandt werden.

Vorzugsweise arbeitet man mit dem Dampf einer siedenden Perfluorverbindung, deren Siedetemperatur mindestens den Wert hat, der für die Härtung des eingesetzten Präpolymeren notwendig ist. Die Siedetemperatur der ausgewählten Perfluorverbindung kann auch einen höheren Wert haben als für den Härtungsprozeß notwendig ist, jedoch bedeutet dies im allgemeinen einen überflüssigen Energieaufwand. Daher benutzt man in einer besonders bevorzugten Ausführungsform der Erfindung den Dampf derjenigen siedenden Perfluorverbindung, deren Siedetemperatur mindestens den für die Härtung notwendigen Wert hat und außerdem diesem notwendigen Wert am nächsten kommt, d.h. möglichst wenig über diesem liegt.

Das Härten von Einkomponenten-Duroplasten in der Dampfphase einer der genannten Perfluorverbindungen ist eine Art Reflow-Technik mit kontinuierlicher Wärmezufuhr (vgl. Lea and Johns, Brazing and Soldering, No. 12, Spring 1987, S. 34 - 39). Die latente Verdampfungswärme dieser Perfluorverbindungen wird verwendet, um viskose Präpolymere, vorzugsweise beim Siedepunkt der eingesetzten Perfluorverbindung, zu vernetzen, d.h. auszuhärten, z.B. um SMD-Teile (Surface Mounted Devices) mit einem Einkomponenten-Kleber auf Epoxidharzbasis auf einer Leiterplatte zu fixieren (Bucher, Elektronik 7/31.03.1988, S. 108 - 113). Ausreichende Mengen eines solchen Klebstoffes werden durch ein Sieb oder durch eine geätzte Metallschablone oder mit einem Dispenser auf die miteinander zu verklebenden Stellen appliziert und wenn nötig vorgetrocknet, falls der Klebstoff ein schwer flüchtiges Lösemittel enthält. In den meisten Fällen ist jedoch bei dem Verfahren mit den erfindungsgemäßen Perfluorverbindungen eine Vortrocknung nicht erforderlich. Anschließend werden die zu verklebenden Bauteile in eine Zone mit heißem Dampf einer der genannten Perfluorverbindungen eingetaucht. Der Dampf kondensiert auf den relativ kalten Oberflächen der eingetauchten Teile. Dabei wird die Verdampfungswärme der Perfluorverbindung frei, der viskose Klebstoff wird vernetzt, ausgehärtet und die Teile an der Klebstelle fixiert. Wenn man dieses Verfahren mit einer siedenden Perfluorverbindung durchführt, ist die Dampftemperatur gleich der Siedetemperatur der gewählten Perfluorverbindung. Diejenigen der erfindungsgemäßen Perfluorverbindungen, die eine einheitliche molekulare Zusammensetzung besitzen, haben einen konstanten Siedepunkt und garantieren so eine präzise Temperaturkontrolle bei einem solchen Klebeprozeß. Die Dämpfe der Perfluorverbindungen verteilen sich schnell über die Flächen der zu verklebenden Bauteile, unabhängig von deren Konstruktion. Die Aushärtung des Klebstoffes dauert nur etwa 2 Minuten. Das bedeutet im Vergleich zu den konventionellen Verfahren mit Infrarot- oder Ultraviolett-Bestrahlung eine erhebliche Zeiteinsparung.

Dieses Dampfphase-Verfahren vollzieht sich in einer nahezu luftfreien Umgebung, so daß Luftfeuchtigkeit von den Klebstoffen nicht absorbiert werden kann. Luftfeuchtigkeit kann nämlich die vollständige Aushärtung behindern. Ein weiterer Vorteil der Perfluorverbindungen besteht darin, daß sie - im Gegensatz zu vielen anderen organischen Flüssigkeiten - wegen ihres inerten Verhaltens weder Kunststoffe noch Metalle angreifen.

Sowohl nach dem Batch-Prinzip arbeitende Standgeräte als auch Continue-Inline-Anlagen sind einsetzbar, wie sie beim Dampfphase-Löten bekannt sind (Bucher, Elektronik 7/31.03.1988, S. 108 - 113; Merkblatt Hoechst AG "Hostinert", Ausgabe Oktober 1989). Bei dem diskontinuierlichen Batch-Verfahren wird oft außer einer der genannten Perfluorverbindungen (Primärmedium) eine obere Sperrschicht, bestehend aus dem Dampf einer Fluorverbindung (Sekundärmedium), z.B. Trichlortrifluorethan verwendet, wobei der Siedepunkt des Sekundärmediums deutlich unter dem des Primärmediums liegt, um dessen Verdunstung zu verhindern. Die kontinuierlich arbeitenden und transportierenden Inline-Anlagen können in einen total automatisierten Produktionsprozeß integriert werden und sind für einen größeren Leistungsausstoß gedacht. Eine Dampfphase aus einem Sekundäremedium ist bei diesen Anlagen nicht notwendig.

Beispiel 1

Drei Epoxidharzplatten wurden mit Aceton entfettet. Auf den Rand von zwei Platten mit den Abmessungen von 25 mm x 105 mm wurde jeweils ein pastöser, lösemittelfreier Einkomponenten-Klebstoff auf Epoxidharzbasis (thixotropierter Klebstoff mit beigemischtem Härter auf Basis eines Anhydrids) in einer Breite von 5 mm aufgetragen und jeweils eine weitere Platte auf die Klebefläche unter leichtem Druck angelegt. Anschließend wurden die beiden Plattenpaare in den Korb eines nach dem Batch-Prinzip arbeitenden Standgerätes gelegt und mit dem Korb durch die obere Sperrschicht des Sekundärdampfes (Trichlortrifluorethan) in die Dampfphase einer siedenden Perfluorverbindung (Primärmedium) mit einem Siedepunkt von 215 °C eingetaucht.

Folgende Perfluorverbindungen wurden eingesetzt:
beim ersten Versuch ein Perfluorpolyethergemisch der Formel

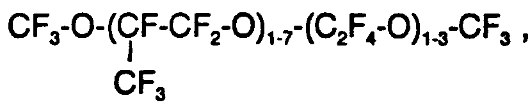

beim zweiten Versuch Perfluortetradecahydrophenanthren $C_{14}F_{24}$ aus der Gruppe der cyclischen Perfluoralkane,
beim dritten Versuch Tris(perfluor-n-pentyl)amin $N(C_5F_{11})_3$ aus der Gruppe der perfluorierten tertiären Amine.

Die zu verklebenden Teile verweilten 20 Sekunden im Primärmedium bei einer Temperatur, die dessen Siedepunkt entsprach. Danach wurde der Korb mit den verklebten Teilen in die Sekundärdampfzone mit einer Temperatur von ca. 150 °C hochgezogen. Die Verweildauer betrug 50 Sekunden. Anschließend wurden die Teile in dem Korb aus dem Schacht der Anlage transportiert und herausgenommen. Um festzustellen, ob das Epoxidharz vernetzt worden war, wurde die Haftung der beiden Verklebungen nach DIN 53 283 "Bestimmung der Bindefestigkeit von einschnittig überlappten Klebungen im Zugversuch" bei Raumtemperatur geprüft. Die Bindefestigkeit betrug bei allen drei Versuchen mindestens 19,2 $N/mm^2$. Damit wurde nachgewiesen, daß die erforderliche Klebfestigkeit erreicht wurde. Während beim konventionellen Heißhärten Vernetzungszeiten von 15 Minuten bei 150 °C, bzw. 5 bis 10 Minuten bei 180 °C, notwendig sind, dauerte der Aushärteprozeß mit den obigen Perfluorverbindungen nur zwei Minuten.

Beispiel 2

Zur Prüfung der Adhäsion der erfindungsgemäßen Perfluorverbindungen an Kunststoffsubstraten sowie der Beständigkeit von Epoxidharzplatten in den Perfluorverbindungen wurden folgende Versuche mit den drei in Beispiel 1 benutzten typischen Vertretern dieser Verbindungen der Reihe nach durchgeführt: Je zwei Epoxidharzplatten wurden 10 mal jeweils 60 Sekunden lang in die Dampfphase einer der siedenden Perfluorverbindungen eingetaucht.
Es wurde geprüft, ob sich die behandelten Epoxidharzplatten im Aussehen, in den Maßen und im Gewicht verändert hatten. Die Platten hatten sich bei der zehnmaligen Behandlung in den drei verschiedenen Dampfphasen nur leicht verfärbt, sich in den Maßen aber nicht verändert. Es trat also keine Quellung auf.

Der Gewichtsverlust lag zwischen 0,5 und 1 %. Da die Behandlung bei den drei Versuchen etwa fünfmal länger als ein Aushärtevorgang eines Klebeprozesses dauerte, kann man davon ausgehen, daß die Kunststoffsubstrate erst recht während eines Klebeprozesses unverändert bleiben würden. Die Gewichtsabnahmen beweisen außerdem, daß keine Reste der Perfluorverbindungen auf solchen Kunststoffsubstraten zurückbleiben, die deren Qualität nach einer Verklebung mit Hilfe dieser Verbindungen beeinträchtigen könnten.

Beispiel 3

Zur Prüfung der Beständigkeit von Metallen in den erfindungsgemäßen Perfluorverbindungen wurden mit Aluminium (99,5 Masse-% Al), Kupfer (99,5 - 99,8 Masse-% Cu) und zwei Edelstahlsorten (Werkstoff Nr. 1.4541 und 1.4571 nach DIN 17 440) Heißkorrosionstests von 40 Stunden nach DIN 50 906 "Korrosionsprüfung in kochenden Flüssigkeiten" nacheinander in den drei in Beispiel 1 verwendeten Perfluorverbindungen mit einem Siedepunkt von 215 °C durchgeführt und nach DIN 50 905 "Chemische Korrosionsuntersuchungen", Blatt 2, ausgewertet. Der Massenverlust lag bei allen Metallen sowohl in der Flüssigphase als auch in der Dampfphase deutlich unter 0,1 $mg/cm^2$. Lediglich bei Kupfer war der

Massenverlust in der Dampfphase geringfügig höher (0,14 mg/cm$^2$). Die behandelten Metalle hatten sich im Aussehen nicht verändert. Aufgrund dieser Versuchsergebnisse, die unter extremen Bedingungen zustande kamen, kann eine Korrosion beim Verkleben von Metallen derartiger Qualitäten ausgeschlossen werden.

## Patentansprüche

1. Verfahren zum Härten von heißhärtbaren Präpolymeren, dadurch gekennzeichnet, daß man die Präpolymeren mit einem Härter mischt und dann mit dem heißen Dampf einer perfluorierten organischen Verbindung in Berührung bringt, wobei der Dampf mindestens die Temperatur hat, die für die Härtung des eingesetzten Präpolymeren notwendig ist, wobei perfluorierte Verbindungen der Formel

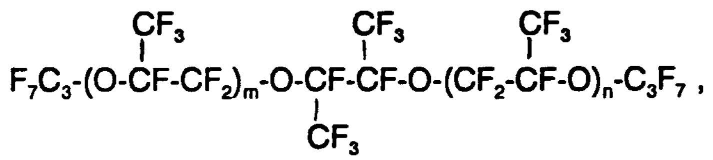

wobei m und n ganze Zahlen von 0 bis 3 sind, und der Formel

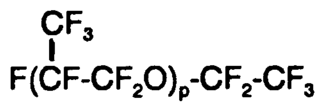 mit p = 1 - 9

ausgenommen sind.

2. Verfahren nach Anspruch 1, dadurch gekennzeichnet, daß man mit dem Dampf einer siedenden Perfluorverbindung arbeitet, deren Siedetemperatur mindestens den Wert hat, der für die Härtung des eingesetzten Präpolymeren notwendig ist.

3. Verfahren nach Anspruch 2, dadurch gekennzeichnet, daß man mit dem Dampf derjenigen Perfluorverbindung arbeitet, deren Siedetemperatur der für die Härtung des eingesetzten Präpolymeren notwendigen Temperatur am nächsten kommt.

4. Verfahren nach einem der Ansprüche 1 bis 3, dadurch gekennzeichnet, daß man als perfluorierte organische Verbindungen geradkettige oder verzweigte Perfluoralkane mit 5 bis 20 C-Atomen einsetzt.

5. Verfahren nach einem der Ansprüche 1 bis 3, dadurch gekennzeichnet, daß man als perfluorierte organische Verbindungen cyclische Perfluoralkane mit 10 bis 20 C-Atomen einsetzt, die auch perfluorierte Alkylsubstituenten enthalten können.

6. Verfahren nach einem der Ansprüche 1 bis 3, dadurch gekennzeichnet, daß man als perfluorierte Verbindungen perfluorierte tertiäre Alkylamine einsetzt, deren Perfluoralkylreste gleich oder verschieden sein können und 1 bis 14 C-Atome haben, wobei zwei der Reste durch O- oder N-Atome verbrückt sein können.

7. Verfahren nach einem der Ansprüche 1 bis 3, dadurch gekennzeichnet, daß man als perfluorierte organische Verbindungen Perfluoraminoether der allgemeinen Formel

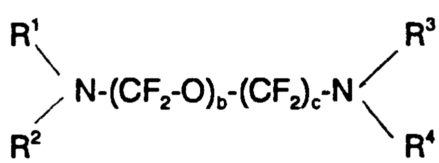

worin bedeuten:
$R^1$ bis $R^4$ gleich oder voneinander verschieden eine Gruppe der Formel
$C_aF_{2a+1}$, wobei a eine ganze Zahl von 1 bis 14 ist,
b, c gleich oder voneinander verschieden eine ganze Zahl von 1 bis 6.

**8.** Verfahren nach einem der Ansprüche 1 bis 3, dadurch gekennzeichnet, daß man als perfluorierte organische Verbindungen Perfluorpolyether der Formel

$R^5$-O-(A)-(B)-(C)-$R^6$

einsetzt, worin bedeuten:

| | |
|---|---|
| $R^5$, $R^6$ | gleich oder voneinander verschieden $C_dR_{2d+1}$, wobei d eine ganze Zahl von 1 bis 4 ist, |
| (A), (B) und (C) | verschieden voneinander eine Gruppe der Formel |

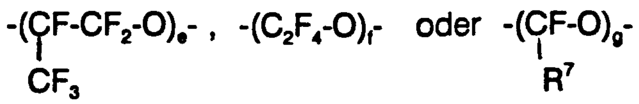

mit

| | |
|---|---|
| $R^7$ = | F oder $CF_3$, |
| e | eine ganze Zahl von 1 bis 7 und |
| f, g | gleich oder unabhängig voneinander verschieden eine ganze Zahl von 0 bis 7. |